# EUROPEAN PATENT SPECIFICATION

(11) **EP 3 171 405 B1**
(45) Date of publication and mention of the grant of the patent: **11.11.2020**
(21) Application number: 16819416.5
(22) Date of filing: 02.02.2016
(51) Int. Cl.: H01L 27/32, H01L 51/52, H01L 27/12, H01L 21/77, G02F 1/133

(54) **DISPLAY SUBSTRATE AND MANUFACTURING METHOD THEREFOR, AND DISPLAY APPARATUS**
ANZEIGESUBSTRAT UND HERSTELLUNGSVERFAHREN DAFÜR SOWIE ANZEIGEVORRICHTUNG
SUBSTRAT D'AFFICHAGE ET SON PROCÉDÉ DE FABRICATION, ET APPAREIL D'AFFICHAGE

(30) Priority: 18.09.2015 CN 201510599701
(43) Date of publication of application: 24.05.2017
(73) Proprietor: BOE Technology Group Co., Ltd., Beijing 100015 (CN); Hefei Xinsheng Optoelectronics Technology Co., Ltd, Anhui 230012 (CN)
(72) Inventor: JIANG, Xuebing, Beijing 100176 (CN); ZHANG, Ran, Beijing 100176 (CN); GAO, Jilei, Beijing 100176 (CN)
(74) Representative: AWA Sweden AB
(86) International application number: PCT/CN2016/073177
(87) International publication number: WO 2017/045337

(56) References cited:
- EP-A1- 2 461 309
- CN-A- 103 713 437
- CN-A- 103 713 437
- CN-A- 105 140 242
- CN-U- 204 927 289
- JP-A- H0 682 769
- JP-A- 2004 111 306
- US-A1- 2013 302 572
- US-A1- 2015 008 408
- US-A1- 2015 108 512

## Description

### BACKGROUND

### 1. Technical Field

The present disclosure relates to the field of display technology, and particularly to a display substrate assembly and a method of manufacturing the same, and a display apparatus.

### 2. Description of the Related Art

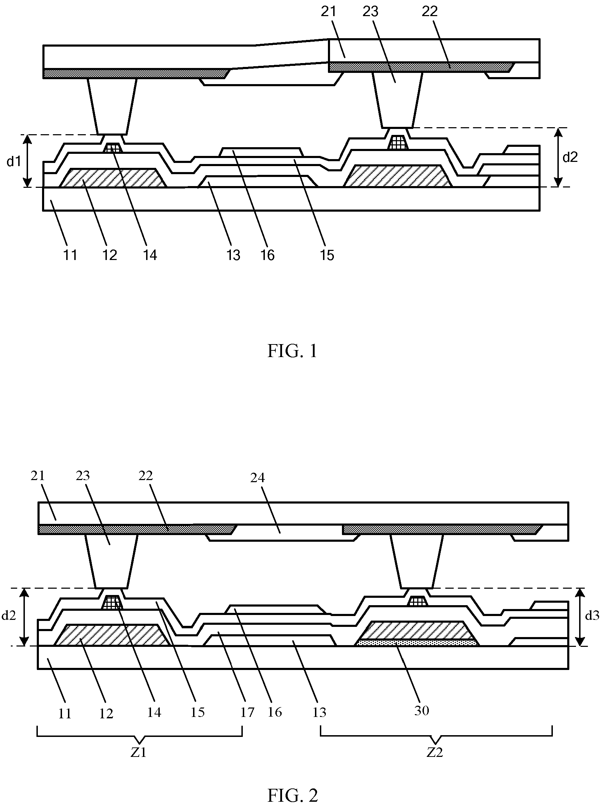

At present, main structure of a display apparatus includes a display substrate assembly. Referring to Fig. 1, a display substrate assembly comprises a first substrate 11 and a second substrate 12 opposite to each other, and, the first substrate 11 is provided with a plurality of functional layers. Provisions of the plurality of functional layers on the first substrate 11, due to influences from the manufacturing processes, easily lead to non-uniformity of total thickness of every region where the plurality of functional layers are provided on the first substrate 11.

For example, when a metal functional layer, e.g., a gate line layer, is formed on the first substrate 11, a metal thin film is firstly deposited, by magnetron sputtering, onto the first substrate 11, and then, a gate line layer is formed by a patterning process. For an array substrate of a large-sized display apparatus (for example, a display apparatus with a size greater than/equal to 32 inches), a metal target used to deposit, by magnetron sputtering, a metal thin film onto the first substrate 11 is usually composed of a plurality of target strips. Region of the first substrate 11 corresponding to a splicing area between two adjacent target strips of the metal target is defined as a first region, while region of the first substrate 11 of the metal target is defined as a second region. Since a film formation rate on the splicing area between two adjacent target strips of the metal target is less than a film formation rate on the non-splicing area of the metal target, after performing the magnetron sputtering, a thickness of the metal thin film within the first region is less than a thickness of the metal thin film within the second region. As a result, in the gate line layer formed by a patterning process, a thickness of the gate line layer within the first region is less than a thickness of the gate line layer within the second region.

From the above, the thickness of the gate line layer within the first region of the first substrate 11 is less than a thickness of the gate line layer within the second region of the first substrate 11, accordingly, in a case that thicknesses of other functional layers within the first region equals to thicknesses of other functional layers within the second region, a total thickness d1 of a plurality of functional layers within the first region of the first substrate 11 is less than a total thicknesses d2 of a plurality of functional layers within the second region, that is, the total thicknesses of the functional layers within different regions of the first substrate 11 are not uniform from each other, namely, d1 is not equal to d2 in Fig. 1. As a result, a thickness of the assembled display substrate assembly formed by assembling the first substrate 11 with the second substrate 21 is uneven, which causes inferior quality of a picture displayed in the display apparatus.

Examples of prior art may be found in the following documents.

US 2015/0108512 A1 discloses a display unit includes a first substrate and a second substrate opposed to each other, a display element having a first electrode and a second electrode on the first substrate, an auxiliary electrode provided on a surface facing the first substrate of the second substrate, and including a plurality of films stacked in a direction from the second substrate to the first substrate, and a plurality of pillars configured to electrically connect the auxiliary electrode to the second electrode.

US 2013/0302572 A1 discloses a film formation substrate arranged such that a base end, in a y-axis direction, of a film-thickness-gradually-diminishing part of a first film overlaps a first film formation region, and a film-thickness-gradually-diminishing part of a second film is disposed on an outside, in the y-axis direction, of a second film formation region and overlaps the film-thicknessgradually-diminishing part of the first film so as to compensate for a gradually diminished thickness of the film-thickness-gradually-diminishing part.

US 2015/0008408 A1 discloses an organic light emitting diode including a hole injection layer, a hole transport layer, an optical compensation layer, an emission layer, an electron transport layer and an electron injection layer.

JP2004111306 A2 discloses an organic LED panel, an apparatus and a method for manufacturing the same.

CN103713437 A discloses an array substrate, a manufacturing method thereof, a liquid crystal display screen and a display device.

EP2461309 A1 discloses a wiring board, a method for manufacturing the same, a display panel, and a display device.

### SUMMARY

An object of the present disclosure is to provide a display substrate assembly, which solve a problem of inferior quality of a picture displayed in a conventional display apparatus caused by non-uniformity of a thickness of a conventional assembled display substrate assembly due to non-uniformity of a total thickness of functional layers of the display substrate assembly.

Another object of the present disclosure is to provide a method of manufacturing a display substrate assembly, which solve a problem of inferior quality manufacturing a display substrate assembly, which solve a problem of inferior quality of a picture displayed in a conventional display apparatus caused by non-uniformity of a thickness of a conventional assembled display substrate assembly due to non-uniformity of a total thickness of functional layers of the display substrate assembly.

Still another object of the present disclosure is to provide a display apparatus, which solve a problem of inferior quality of a picture displayed in a conventional display apparatus caused by non-uniformity of a thickness of a conventional assembled display substrate assembly due to non-uniformity of a total thickness of functional layers of the display substrate assembly.

In order to achieve the above objects, the present disclosure provides the present invention which is defined in the appended claims.

### BRIEF DESCRIPTION OF THE DRAWINGS

The drawings illustrated herein are used for provide a more clear understanding of the present disclosure, and constitute a part of the present disclosure. Exemplary embodiments in the present disclosure as well as the description thereof are provided for explaining the present invention, but are not constructed to limit the present invention. In these drawings,
Fig. 1 is a sectional view of a display substrate assembly in prior art;
Fig. 2 is a sectional view of a display substrate assembly according to an embodiment of the present disclosure;
Fig. 3 is a sectional view of another display substrate assembly according to an embodiment of the present disclosure;
Fig. 4 is a sectional view of still another display substrate assembly according to an embodiment of the present disclosure;
Fig. 5 is a sectional view of yet another display substrate assembly according to an embodiment of the present disclosure;
Fig. 6 shows a flow chart of a method of manufacturing a display substrate assembly according to an embodiment of the present disclosure;
Fig. 7 shows a flow chart of another method of manufacturing a display substrate assembly according to an embodiment of the present disclosure;
Fig. 8 shows a flow chart of still another method of manufacturing a display substrate assembly according to an embodiment of the present disclosure; and
Fig. 9 shows a flow chart of yet another method of manufacturing a display substrate assembly according to an embodiment of the present disclosure.

**Reference Signs**

| | |
|---|---|
| 11-first substrate | 12-gate line |
| 13-common electrode layer | 14-spacer pad |
| 15-passivation layer | 16-pixel electrode layer |
| 21 -second substrate | 22-layer of black matrix |
| 23-spacer | 30-thickness compensation layer |
| 31-first compensation layer | 32-second compensation layer |

### DETAILED DESCRIPTION OF THE EMBODIMENTS

In order to provide a more clear understanding on a display substrate assembly and a method of manufacturing the same, and a display apparatus according to the embodiments of the present disclosure, the embodiments of the present disclosure will be further described hereinafter in detail and completely with reference to the attached drawings.

Referring to Fig. 2, a display substrate assembly according to an embodiment of the present disclosure comprises a first substrate 11 and a second substrate 21 opposite to each other, the first substrate 11 comprises a first region and a second region, and, a total thickness of functional layers within the first region is less than a total thickness of functional layers within the second region, of the first substrate 11. A thickness compensation layer 30 is provided between the first substrate 11 and the second substrate 21 (specifically, the thickness compensation layer 30 is provided at least on at least one of the first substrate 11 and the second substrate 21). A position of the thickness compensation layer 30 corresponds to a position of the first region, and, a sum of thickness of a thickness of the thickness compensation layer 30 and the total thickness of the functional layers within the first region equals to the total thickness of the functional layers within the second region.

In the display substrate assembly according to an embodiment of the present disclosure, the thickness compensation layer 30 is provided between the first substrate 11 and the second substrate 21, the position of the thickness compensation layer 30 corresponds to a position of the first region, and, a sum d3 of thickness of a thickness of the thickness compensation layer 30 and the total thickness of the functional layers within the first region equals to the total thickness d2 of the functional layers within the second region, that is, d2 equals to d3 in Fig. 2, Fig. 3 and Fig. 4, accordingly, after assembling the first substrate 11 with the second substrate 21, the thickness compensation layer 30 can be used to compensate a thickness difference between a region of the display substrate assembly corresponding to the first region and a region of the display substrate assembly corresponding to the second region, so that the thickness of the region of the assembled display substrate assembly corresponding to the first region is the same as that of the region of the assembled display substrate assembly corresponding to the second region, that is, the thickness of the assembled display substrate assembly everywhere is the same. As a result, non-uniformity of the thickness of the assembled display substrate assembly, caused due to non-uniformity of thicknesses of the metal functional layers located on the display substrate assembly, can be eliminated, to improve quality of a picture displayed in the display apparatus.

It should be mentioned that, in order to further control the thicknesses of regions of the assembled display substrate assembly everywhere, after forming functional layers on the first substrate 11 and the second substrate 21 respectively and correspondingly, flat layer(s) can be formed above the first substrate 11 and/or above the second substrate 21, to uniform the thicknesses of regions of the assembled display substrate assembly, after assembling the first substrate 11 with the second substrate 21, everywhere, so as to further control the thicknesses of regions of the assembled display substrate assembly everywhere, thereby improving quality of a picture displayed in the display apparatus.

In the abovementioned embodiments, the thickness compensation layer 30 may be provided on the first substrate 11, or may be provided on the second substrate 21, or may be provided on both the first substrate 11 and the second substrate 21. In these embodiments of the present disclosure, several configurations are presented exemplarily as follows.

In a first configuration, referring to Fig. 2, a common electrode layer 13 and a gate line layer consisted of gate lines 12, a passivation layer 15 and a pixel electrode layer 16 and the like, which are patterned, are superimposed in sequence on the first substrate 11, the thickness compensation layer 30 is located between the gate lines 12 within the first region and the first substrate 11, and the thickness compensation layer 30 is provided in the same layer with the common electrode layer 13 but is not connected to the common electrode layer 13. The thickness compensation layer 30, which is provided in the same layer with the common electrode layer 13 but is not connected to the common electrode layer 13, is provided within the first region of the first substrate 11, to compensate the total thickness of the functional layers within the first region of the first substrate 11, so that, in Fig. 2, a sum d3 of the thicknesses of the thickness compensation layer 30 and of the plurality of functional layers within the first region equals to the total thickness d2 of the plurality of functional layers within the second region, and, after assembling the first substrate 11 with the second substrate 21, the thicknesses of regions of the assembled display substrate assembly everywhere are the same, thereby improving quality of a picture displayed in the display apparatus.

Moreover, the thickness compensation layer 30 is provided in the same layer with the common electrode layer 13. In the manufacture of an array substrate, after depositing a common electrode thin film layer on the first substrate 11, the thickness compensation layer 30 and the common electrode layer 13 can be formed simultaneously by one patterning process. Compared to the forming of the thickness compensation layer 30 on the first substrate 11 alone, it can reduce steps of the process of manufacturing the array substrate and the number of usages of the masks, thereby saving the time and saving the cost. In addition, the thickness compensation layer 30 is not connected to the common electrode layer 13, accordingly, provision of the thickness compensation layer 30 does not bring any influence and interference on a signal transferred in the common electrode layer 13.

It should be mentioned that, continuing to see Fig. 2, in the first configuration, the thickness compensation layer 30 is located between the gate lines 12 within the first region and the first substrate 11, and the thickness compensation layer 30 is in contact with the gate lines 12. As a result, resistance of the gate lines 12 can be reduced, thereby decreasing attenuation of the signal transferred in the gate lines 12.

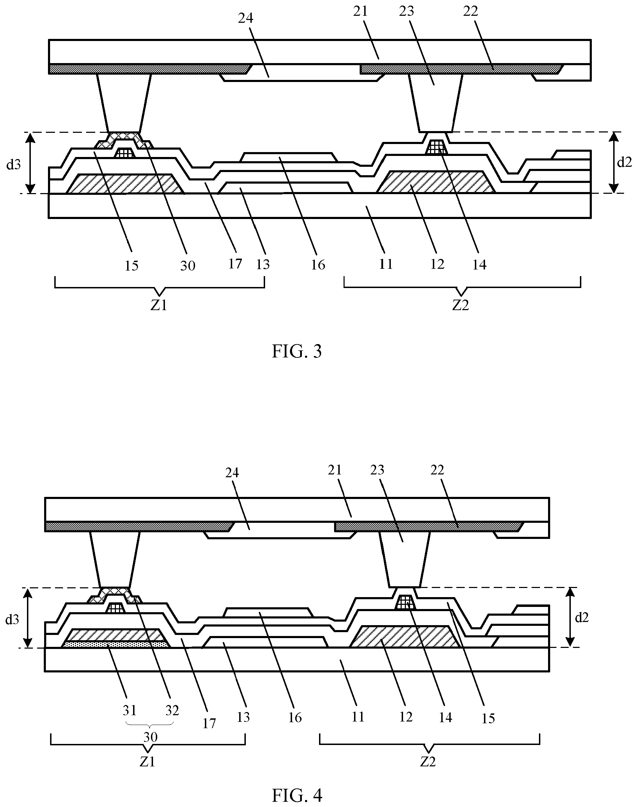

In a second configuration, referring to Fig. 3, a common electrode layer 13, a gate line layer consisted of gate lines 12, a gate insulation layer (not shown in figure), an active layer (not shown in figure), a source-drain layer (not shown in figure), a passivation layer 15 and a pixel electrode layer 16, which are patterned, are superimposed in sequence on the first substrate 11. The thickness compensation layer 30 is located on the passivation layer 15 within the first region, and the thickness compensation layer 30 is provided in the same layer with the pixel electrode layer 16 but is not connected to the pixel electrode layer 16. In a specific implementation, the pixel electrode layer 16 is located above the common electrode layer 13 and corresponds to the common electrode layer 13 located on the first substrate 11. The thickness compensation layer 30 is located on the passivation layer 15 within the first region of the first substrate 11, and is located right above the gate lines 12 within the first region. The thickness compensation layer 30 is provided in the same layer with the pixel electrode layer 16 but is not connected to the pixel electrode layer 16. When the first substrate 11 is assembled with the second substrate 21, a spacer 23 within a region of the second substrate 20 corresponding to the first region is in contact with the thickness compensation layer 30. The thickness compensation layer 30, which is provided in the same layer with the pixel electrode layer 16 but is not connected to the pixel electrode layer 16, is provided within the first region of the first substrate 11, to compensate the total thickness of the functional layers within the first region of the first substrate 11, so that, in Fig. 3, a sum d3 of the thicknesses of the thickness compensation layer 30 and of the plurality of functional layers within the first region equals to the total thickness d2 of the plurality of functional layers within the second region, and, after assembling the first substrate 11 with the second substrate 21, the thicknesses of regions of the assembled display substrate assembly everywhere are uniformed, thereby improving quality of a picture displayed in the display apparatus. In addition, the thickness compensation layer 30 is not connected to the pixel electrode layer 16, which can prevent the thickness compensation layer 30 to create an interference electric field and thus can prevent any influence and interference on the pixel electrode layer 16.

It should be mentioned that, the thickness compensation layer 30 is provided in the same layer with the pixel electrode layer 16. In the manufacture of an array substrate 10, after depositing a pixel electrode thin film layer on the first substrate 11, the thickness compensation layer 30 and the pixel electrode layer 16 can be formed simultaneously by one patterning process. Compared to the forming of the thickness compensation layer 30 on the first substrate 11 alone, it can reduce steps of the process of manufacturing the array substrate 10 and the number of usages of the masks, thereby saving the time and saving the cost.

Moreover, the thickness compensation layer 30 is provided in the same layer with the pixel electrode layer 163. A thickness of the pixel electrode thin film layer can be obtained by measuring, after the forming of the passivation layer 15 on the first substrate 11, a total thickness of the formed functional layers within these regions of the first substrate 11. So that, a suitable thickness of the pixel electrode thin film layer can be selected, to match the thickness of the thickness compensation layer 30 obtained after the patterning process with a thickness required to be compensated. Compared with the thickness compensation layer 30 formed in the first configuration, the thickness compensation layer 30 formed in the second configuration has a thickness that can match with the thickness required to be compensated in a better manner, so that it can compensate much more accurately the total thickness of the plurality of functional layers within the first region of the first substrate 11, thereby further improving quality of a picture displayed in the display apparatus.

In a third configuration, referring to Fig. 4, a common electrode layer 13, a gate line layer consisted of gate lines 12, a gate insulation layer (not shown in figure), an active layer (not shown in figure), a source-drain layer (not shown in figure), a passivation layer 15 and a pixel electrode layer 16, which arc patterned, arc superimposed in sequence on the first substrate 11. The thickness compensation layer 30 further comprises a first compensation layer 31 and a second compensation layer 32, wherein, the first compensation layer 31 is located between the gate lines 12 within the first region and the first substrate 11, and the first compensation layer 31 is in contact respectively with the gate lines 12 and the first substrate 11. The first compensation layer 31 is provided in the same layer with the common electrode layer 13 but is not connected to the common electrode layer 13. The second compensation layer 32 is located on the passivation layer 15 within the first region, and the second compensation layer 32 is provided in the same layer with the pixel electrode layer 16 but is not connected to the pixel electrode layer 16. For example, the common electrode layer 13 is located on the first substrate 11, and, the pixel electrode layer 16 is located above the common electrode layer 13 and corresponds to the common electrode layer 13. The thickness compensation layer 30 comprises a first compensation layer 31 provided in the same layer with the common electrode layer 13 but is not connected to the common electrode layer 13, and a second compensation layer 32 provided in the same layer with the pixel electrode layer 16 but is not connected to the pixel electrode layer 16. The first compensation layer 31 is located between the gate lines 12 within the first region and the first substrate 11, and, the second compensation layer 32 is located on the passivation layer 16 right above the gates line 12 within the first region. After assembling the first substrate 11 with the second substrate 21, a spacer 23 within a region of the second substrate 21 corresponding to the first region is in contact with the second compensation layer 32.

The first compensation layer 31 which is provided in the same layer with the common electrode layer 13 and the second compensation layer 32 which is provided in the same layer with the pixel electrode layer 16 are provided, to compensate the total thickness of the plurality of functional layers within the first region of the first substrate 11, so that, in Fig. 4, a sum d3 of the thicknesses of the thickness compensation layer and of the plurality of functional layers within the first region equals to the total thickness d2 of the plurality of functional layers within the second region, and thus, after assembling the first substrate 11 with the second substrate 21, the thicknesses of regions of the assembled display substrate assembly everywhere are the same, so as to prevent non-uniformity of the thickness of the assembled display substrate assembly caused due to non-uniformity of the total thickness of the functional layers of the first substrate 11, thereby improving quality of a picture displayed in the display apparatus.

It should be mentioned that, in the third configuration, after depositing the passivation layer 15 on the first substrate 11, the second compensation layer 32 which is provided in the same layer with the pixel electrode layer 16 is formed by one patterning process, to compensate the total thickness of the functional layers within the first region of the first substrate 11. Here, the second compensation layer 32 is not only can compensate the total thickness of the plurality of functional layers within the first region of the first substrate 11, but also can compensate the total thickness of the functional layers which is required to be compensated within the second region of the first substrate 11, so that the thicknesses of regions of the assembled display substrate assembly everywhere are the same.

In the abovementioned embodiments, these configurations of the thickness compensation layer 30 are illustrated and explained on the assumption that it is disposed on a first substrate 11 of an ADS type array substrate, although the display substrate assembly according to embodiments of the present disclosure is not limited to be suitable for ADS type array substrate. In addition, these configurations of the thickness compensation layer 30 include but are not limited to the three ones addressed in the abovementioned embodiments, for example, the thickness compensation layer 30 can be provided in the same layer with other functional layers including an active layer and so on, and it will not describe repetitively herein.

In the first, second and third configurations, the thickness compensation layer 30 is provided on the first substrate 11, nevertheless, the thickness compensation layer 30 can also be provided on the second substrate 21 opposite to the first substrate 11.

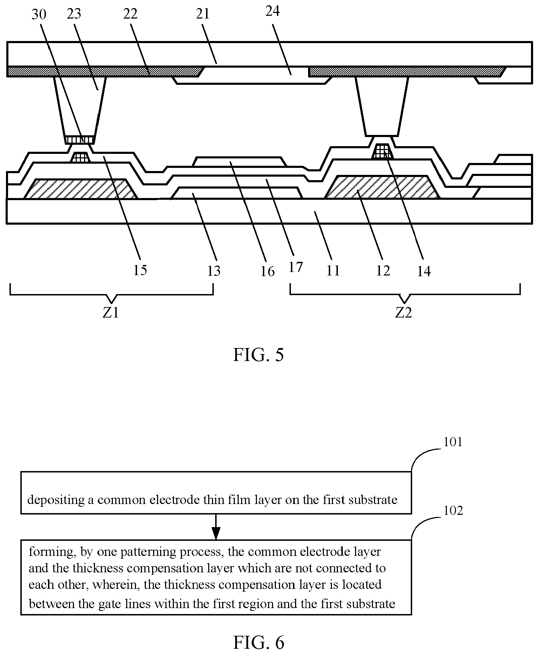

In a fourth configuration, referring to Fig. 5, a layer 22 of black matrix, a color film layer (not shown in figure), a spacer layer consisted of spacers 23, which are patterned, are superimposed in sequence on the second substrate 21. The thickness compensation layer 30 is located on the spacer layer within a region of the second substrate 21 corresponding to the first region. In a specific implementation, the layer 22 of black matrix of the second substrate 21 corresponds in position to the gate lines 12 of the first substrate 11, the spacer layer comprises a plurality of spacers 23 provided on the layer 22 of black matrix, and, the thickness compensation layer 30 is located on the spacer 23 within the region of the second substrate corresponding to the first region 21. When the first substrate 11 is assembled with the second substrate 21, a sum of thickness of a thickness of the thickness compensation layer 30 and the total thickness of the functional layers within the first region of the first substrate 11 equals to the total thickness of the functional layers within the second region of the first substrate 11, that is, the thickness of the assembled display substrate assembly everywhere is the same. As a result, quality of a picture displayed in the display apparatus is improved. Material for the thickness compensation layer 30 of the second substrate 21 can be the same as material for the spacers 23, or can be different from material for the spacers 23.

It should be mentioned that, when it is provided on the second substrate 21, the thickness compensation layer 30 may be provided on the spacer 23 within the region of the second substrate 21 corresponding to the first region, or may be provided within the region of the second substrate 21 corresponding to the first region but between the layer 22 of black matrix and the spacer layer, or also may be provided within the region of the second substrate 21 corresponding to the first region but between the layer 22 of black matrix and the second substrate 21.

In these abovementioned embodiments, the thickness compensation layer 30 is provided on the first substrate 11 or on the second substrate 21. In other embodiments, the thickness compensation layer 30 can be provided both on the first substrate 11 and on the second substrate 21. In case that the thickness compensation layer 30 is provided both on the first substrate 11 and on the second substrate 21, any one of the first, second and third configurations, or any other similar configurations, may be adopted as configuration of the thickness compensation layer 30 on the first substrate 11, while the fourth configuration, or any other similar configurations, may be adopted as configuration of the thickness compensation layer 30 on the second substrate 21, and it will not be introduced one by one herein.

In these abovementioned embodiments, the functional layers on the first substrate 11 includes a common electrode layer 13, a gate line layer, a gate insulation layer, an active layer, a source-drain layer, a passivation layer 15 and a pixel electrode layer 16 and so on. In an example, the gate line layer and the source-drain layer are metal functional layers.

According to embodiments of the present disclosure, continuing to see Fig. 2 to Fig. 5, a plurality of spacer pads 14 are provided above the first substrate 11, and, the plurality of spacer pads 14 are provided in the same layer with the source-drain layer but are not connected to the source-drain layer. The thickness compensation layer 30 comprises thickness compensation pads corresponding, one by one, to the spacer pads 14 within the first region, and, orthographic projections of the spacer pads 14 within the first region onto the first substrate 11 fall into orthographic projections of the corresponding thickness compensation pads onto the first substrate 11. That is to say, the thickness compensation layer 30 is consisted of a plurality of thickness compensation pads.

For example, referring to Fig. 2, one thickness compensation pad is provided right below each spacer pad 14 within the first region, and the thickness compensation pad provided right below each spacer pad 14 is not connected to the thickness compensation pad provided right below another spacer pad 14, and, orthographic projections of the spacer pads 14 onto the first substrate 11 fall into orthographic projections of the corresponding thickness compensation pads onto the first substrate 11. Referring to Fig. 3, one thickness compensation pad is provided right above each spacer pad 14 within the first region, and the thickness compensation pad provided right above each spacer pad 14 is not connected to the thickness compensation pad provided right above another spacer pad 14, and, orthographic projections of the spacer pads 14 onto the first substrate 11 fall into orthographic projections of the corresponding thickness compensation pads onto the first substrate 11. Referring to Fig. 4, the thickness compensation layer 30 comprises: a first compensation layer 31 provided right below each spacer pad 14 within the first region, and, a second compensation layer 32 provided right above each spacer pad 14 within the first region. The first compensation layer 31 comprises first compensation pads corresponding, one by one, to the spacer pads 14 within the first region, and, the second compensation layer 32 comprises second compensation pads corresponding, one by one, to the spacer pads 14 within the first region. The first compensation pad provided right below each spacer pad 14 is not connected to the thickness compensation pad provided right below another spacer pad 14, and, the second compensation pad provided right above each spacer pad 14 is not connected to the second compensation pad provided right above another spacer pad 14. Orthographic projections of the spacer pads 14 onto the first substrate 11 fall into orthographic projections of the first compensation pads and the second compensation pads onto the first substrate 11. Referring to Fig. 5, a thickness compensation pad is provided on each spacer 23 within the region of the second substrate 21 corresponding to the first region, and the thickness compensation pad provided on each spacer 23 is not connected to the thickness compensation pad provided on another spacer 23, and, orthographic projections of the spacer pads 14 onto the first substrate 11 fall into orthographic projections of the corresponding thickness compensation pads onto the first substrate 11.

The thickness compensation layer 30 is provided within the first region of the first substrate 11 and/or within a region of the second substrate 21 corresponding to the first region, and, orthographic projections of the spacer pads 14 within the first region onto the first substrate 11 fall into orthographic projections of the corresponding thickness compensation pads onto the first substrate 11. The spacer pad 14 is provided right above the gate lines 12 while the gate lines 12 correspond in position to the layer 22 of black matrix, accordingly, the thickness compensation layer 30 corresponds in position to the gate lines 12, and also corresponds in position to the layer 22 of black matrix. That is, provision of the thickness compensation layer 30 does not occupy a space where a pixel region of the display substrate assembly is, thereby preventing decrement of aperture opening ratio of the display substrate assembly.

A display apparatus is further provided according to embodiments of the present disclosure. The display apparatus is provided with the display substrate assembly according to the abovementioned embodiments. Compared to the prior art, the display apparatus has the same advantages as the abovementioned display substrate assembly, and thus it will not describe repetitively herein.

A method of manufacturing a display substrate assembly is further provided according to embodiments of the present disclosure. The method is of manufacturing the display substrate assembly according to the abovementioned embodiments, and it comprises:
providing a first substrate and a second substrate, the first substrate comprising a first region and a second region, and, a total thickness of functional layers within the first region being less than a total thickness of functional layers within the second region, of the first substrate; and
forming a thickness compensation layer within the first region of the first substrate, or/and, forming the thickness compensation layer within a region of the second substrate corresponding to the first region, a sum of thickness of a thickness of the thickness compensation layer and the total thickness of the functional layers within the first region being equal to a total thickness of the functional layers within the second region.

These embodiments illustrated and described in this disclosure are provided in a progressive manner, and same or similar parts of these embodiments will be adopted from each other. However, every embodiment highlights on its difference from the others. Especially, for these method embodiments, they are generally similar to those product embodiments and therefore the description on them is simple relatively, and same or similar parts of these method embodiments will be adopted from those of the product embodiments.

Referring to Fig. 6, which illustrates an embodiment where a thickness compensation layer is provided on the first substrate. The step of forming the thickness compensation layer within the first region of the first substrate comprises:
a step 101 of depositing a common electrode thin film layer on the first substrate; and
a step 102 of forming, by one patterning process, the common electrode layer and the thickness compensation layer which are not connected to each other, wherein, the thickness compensation layer is located between the gate lines within the first region and the first substrate.

In the abovementioned embodiment, the thickness compensation layer is provided in the same layer with the common electrode layer. In practical applications, the thickness compensation layer may also be provided in the same layer with the pixel electrode layer.

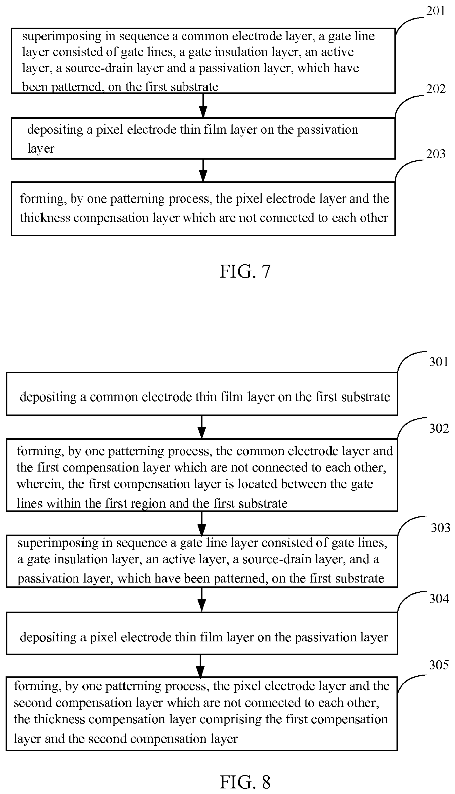

Referring to Fig. 7, the step of forming the thickness compensation layer within the first region of the first substrate comprises:
a step 201 of superimposing in sequence a common electrode layer, a gate line layer consisted of gate lines, a gate insulation layer, an active layer, a source-drain layer and a passivation layer, which have been patterned, on the first substrate;
a step 202 of depositing a pixel electrode thin film layer on the passivation layer; and
a step 203 of forming, by one patterning process, the pixel electrode layer and the thickness compensation layer which are not connected to each other.

In the abovementioned embodiment, the thickness compensation layer is provided in the same layer with the common electrode layer, or, the thickness compensation layer is provided in the same layer with the pixel electrode layer. Moreover, the thickness compensation layer may further comprises a first compensation layer provided in the same layer with the common electrode layer and a second compensation layer provided in the same layer with the second compensation layer.

Referring to Fig. 8, the step of forming the thickness compensation layer within the first region of the first substrate comprises:
a step 301 of depositing a common electrode thin film layer on the first substrate; and
a step 302 of forming, by one patterning process, the common electrode layer and the first compensation layer which are not connected to each other, wherein, the first compensation layer is located between the gate lines within the first region and the first substrate;
a step 303 of superimposing in sequence a gate line layer consisted of gate lines, a gate insulation layer, an active layer, a source-drain layer, and a passivation layer, which have been patterned, on the first substrate;
a step 304 of depositing a pixel electrode thin film layer on the passivation layer; and
a step 305 of forming, by one patterning process, the pixel electrode layer and the second compensation layer which are not connected to each other, the thickness compensation layer comprising the first compensation layer and the second compensation layer.

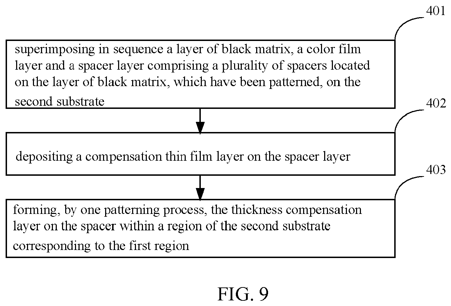

Referring to Fig. 9, the step of forming the thickness compensation layer within the second substrate corresponding to the first region of the first substrate comprises:
a step 401 of superimposing in sequence a layer of black matrix, a color film layer and a spacer layer comprising a plurality of spacers located on the layer of black matrix, which have been patterned, on the second substrate;
a step 402 of depositing a compensation thin film layer on the spacer layer; and
a step 403 of forming, by one patterning process, the thickness compensation layer on the spacer within a region of the second substrate corresponding to the first region.

## Claims

1. A display substrate assembly, comprising a first substrate (11) and a second substrate (21) opposite to each other, the first substrate (11) comprising a first region (Z1) and a second region (Z2), and, a total thickness of functional layers (12, 13, 14, 15, 16) within the first region (Z1) being less than a total thickness of functional layers (12, 13, 14, 15, 16) within the second region (Z2), of the first substrate (11); wherein,
a thickness compensation layer (30) is provided on the first substrate (11), a position of the thickness compensation layer (30) corresponds to a position of the first region (Z1), and, a sum of thickness of a thickness of the thickness compensation layer (30) and the total thickness of the functional layers (12, 13, 14, 15, 16) within the first region (Z1) equals to a total thickness of the functional layers (12, 13, 14, 15, 16) within the second region (Z2);
**characterized in that**,
a plurality of spacer pads (14) are provided above the first substrate (11); wherein the plurality of spacer pads (14) are provided in the same layer with a source-drain layer but are not connected to the source-drain layer, wherein the thickness compensation layer comprises the plurality of spacer pads (14), such that the spacer pads (14) are thickness compensation pads (14), wherein the thickness compensation pads (14) are provided at locations corresponding to spacers (23) provided on the second substrate (21).

2. The display substrate assembly of claim 1, wherein the functional layers comprise
a common electrode layer (13) and a gate line layer consisting of gate lines (12), which are patterned, disposed on the first substrate (11), and wherein the thickness compensation layer (30) is located between the gate line (12) within the first region (Z1) and the first substrate (11), and the thickness compensation layer (30) is provided in the same layer with the common electrode layer (13) but is not connected to the common electrode layer (13).

3. The display substrate assembly of claim 1, wherein the functional layers comprise
a common electrode layer (13) and a gate line layer consisting of gate lines (12) disposed on the first substrate (11);
a gate insulation layer (17) disposed on the common electrode layer and the gate line layer;
an active layer, the source-drain layer, and a passivation layer (15) disposed in this order on the gate insulation layer; and a pixel electrode layer (16) provided on the passivation layer; and wherein the thickness compensation layer (30) is located on the passivation layer (15) within the first region (Z1), and the thickness compensation layer (30) is provided in the same layer with the pixel electrode layer (16) but is not connected to the pixel electrode layer (16).

4. The display substrate assembly of claim 1, wherein the functional layers comprise
a common electrode layer (13) and a gate line layer consisting of gate lines (12) disposed on the first substrate;
a gate insulation layer (17) disposed on the common electrode layer and the gate line layer;
an active layer, a source-drain layer, and a passivation layer (15) disposed in this order on the date insulation layer; and a pixel electrode layer (16) provided on the passivation layer; and wherein the thickness compensation layer (30) further comprises a first compensation layer (31) and a second compensation layer (32), wherein the first compensation layer (31) is located between the gate line (12) within the first region (Z1) and the first substrate (11) and is provided in the same layer with the common electrode layer (13) but is not connected to the common electrode layer (13), and, the second compensation layer (32) is located on the passivation layer (15) within the first region (Z1), and is provided in the same layer with the pixel electrode layer (16) but is not connected to the pixel electrode layer (16).

5. The display substrate assembly of claim 1, **characterized in that**, a layer of black matrix (22), a color film layer (24) and a spacer layer (23), which are patterned, are superimposed in sequence on the second substrate (21); and, the thickness compensation layer (30) is located on the spacer layer (23) within a region of the second substrate (21) corresponding to the first region (Z1).

6. The display substrate assembly of claim 1, **characterized in that**, the functional layers comprise metal functional layers.

7. A display apparatus, **characterized in that**, the display apparatus is provided with the display substrate assembly of any one of claims 1-6.

8. A method of manufacturing the display substrate assembly of claim 1, the method comprising providing the first substrate (11) and the second substrate (21), forming functional layers and forming the thickness compensation layer (30).

9. The method of manufacturing the display substrate assembly, of claim 8, wherein the functional layers comprise a common electrode layer (13), a gate line layer, a gate insulation layer, an active layer, a source-drain layer, and a passivation layer, and the step of forming the thickness compensation layer (30) within the first region (Z1) of the first substrate (11) comprises:
depositing a common electrode thin film layer on the first substrate (11); and
forming, by one patterning process, the common electrode layer (13) and the thickness compensation layer (30) which are not connected to each other, wherein, the thickness compensation layer (30) is located between the gate line (12) within the first region (Z1) and the first substrate (11).

10. The method of manufacturing the display substrate assembly, of claim 8, **characterized in that**, the step of forming the thickness compensation layer (30) within the first region (Z1) of the first substrate (11) comprises:
providing a common electrode layer (13) and a gate line layer consisting of gate lines (12) on the first substrate, providing a gate insulation layer (17) on the common electrode layer and the gate line layer, providing an active layer, a source-drain layer and a passivation layer (15) on the gate insulation layer;
depositing a pixel electrode thin film layer on the passivation layer (15); and
forming, by one patterning process, a pixel electrode layer (16) and the thickness compensation layer (30) which are not connected to each other.

11. The method of manufacturing the display substrate assembly, of claim 8, **characterized in that**, the step of forming the thickness compensation layer (30) within the first region (Z1) of the first substrate (11) comprises:
depositing a common electrode thin film layer on the first substrate (11); and
forming, by one patterning process, the common electrode layer (13) and a first compensation layer (31) which are not connected to each other, wherein, the first compensation layer (31) is located between the gate lines (12) within the first region (Z1) and the first substrate (11), and, the first compensation layer (31) is in contact respectively with the gate lines (12) and the first substrate (11);
providing a gate line layer consisting of gate lines (12) in the same layer as the common electore layer, a gate insulation layer (17) on the common electrode layer and the gate line layer, and an active layer, a source-drain layer, and a passivation layer (15) on the gate insulation layer;
depositing a pixel electrode thin film layer on the passivation layer (15); and
forming, by one patterning process, the pixel electrode layer (16) and a second compensation layer (32) which are not connected to each other, the thickness compensation layer (30) comprising the first compensation layer (31) and the second compensation layer (32).

12. The method of manufacturing the display substrate assembly, of claim 8, **characterized in that**, the step of forming the thickness compensation layer (30) within a region of the second substrate (21) corresponding to the first region (Z1) comprises:
providing a layer of black matrix (22), a color film layer (24) and a spacer layer (23) comprising a plurality of spacers located on the layer of black matrix (22), which have been patterned, on the second substrate (21) **in that** order;
depositing a compensation thin film layer on the spacer layer (23); and
forming, by one patterning process, the thickness compensation layer (30) on the spacer within a region of the second substrate (21) corresponding to the first region (Z1).

## Patentansprüche

1. Anzeigesubstratanordnung, ein erstes Substrat (11) und ein zweites Substrat (21) aufweisend, die einander gegenüberliegen, wobei das erste Substrat (11) einen ersten Bereich (Z1) und einen zweiten Bereich (Z2) aufweist, und wobei die Gesamtdicke der Funktionsschichten (12, 13, 14, 15, 16) innerhalb des ersten Bereichs (Z1) kleiner ist als die Gesamtdicke der Funktionsschichten (12, 13, 14, 15, 16) innerhalb des zweiten Bereichs (Z2) des ersten Substrats (11); wobei,
eine Dickenausgleichsschicht (30) auf dem ersten Substrat (11) vorgesehen ist, eine Position der Dickenausgleichsschicht (30) einer Position des ersten Bereichs (Z1) entspricht, und eine Summe der Dicke einer Dicke der Dickenausgleichsschicht (30) und der Gesamtdicke der Funktionsschichten (12, 13, 14, 15, 16) innerhalb des ersten Bereichs (Z1) gleich einer Gesamtdicke der Funktionsschichten (12, 13, 14, 15, 16) innerhalb des zweiten Bereichs (Z2) ist;
**dadurch gekennzeichnet, dass**,
mehrere Abstandhalterkissen (14) oberhalb des ersten Substrat (11) vorgesehen sind; wobei die mehreren Abstandhalterkissen (14) in der gleichen Schicht mit einer Source-Drain-Schicht versehen sind, aber nicht mit der Source-Drain-Schicht verbunden sind,
wobei die Dickenausgleichsschicht die mehreren Abstandhalterkissen (14) aufweist, so dass die Abstandhalterkissen (14) Dickenkompensationskissen (14) sind, wobei die Dickenkompensationskissen (14) an Stellen vorgesehen sind, die Abstandhaltern (23) entsprechen, die auf dem zweiten Substrat (21) vorgesehen sind.

2. Anzeigesubstratanordnung nach Anspruch 1, wobei die Funktionsschichten aufweisen:
eine gemeinsame Elektrodenschicht (13) und eine Gate-Leitungsschicht, die, angeordnet auf dem ersten Substrat (11), aus Gate-Leitungen (12) hergestellt ist, die strukturiert sind,
und wobei die Dickenausgleichsschicht (30) zwischen der Gate-Leitung (12) innerhalb des ersten Bereichs (Z1) und dem ersten Substrat (11) angeordnet ist und die Dickenausgleichsschicht (30) in der gleichen Schicht mit der gemeinsamen Elektrodenschicht (13) vorgesehen ist, aber nicht mit der gemeinsamen Elektrodenschicht (13) verbunden ist.

3. Anzeigesubstratanordnung nach Anspruch 1, wobei die Funktionsschichten aufweisen:
eine gemeinsame Elektrodenschicht (13) und eine Gate-Leitungsschicht, die aus Gate-Leitungen (12) hergestellt ist, die auf dem ersten Substrat (11) angeordnet sind;
eine Gate-Isolierschicht (17), die auf der gemeinsamen Elektrodenschicht und der Gate-Leitungsschicht angeordnet ist;
eine aktive Schicht, die Source-Drain-Schicht und eine Passivierungsschicht (15), die in dieser Reihenfolge auf der Gate-Isolierschicht angeordnet sind; und
eine Pixelelektrodenschicht (16), die auf der Passivierungsschicht vorgesehen ist;
und wobei die Dickenausgleichsschicht (30) auf der Passivierungsschicht (15) innerhalb des ersten Bereichs (Z1) angeordnet ist, und die Dickenausgleichsschicht (30) in der gleichen Schicht wie die Pixelelektrodenschicht (16) vorgesehen ist, aber nicht mit der Pixelelektrodenschicht (16) verbunden ist.

4. Anzeigesubstratanordnung nach Anspruch 1, wobei die Funktionsschichten aufweisen:
eine gemeinsame Elektrodenschicht (13) und eine Gate-Leitungsschicht, die aus Gate-Leitungen (12) hergestellt sind, die auf dem ersten Substrat angeordnet sind;
eine Gate-Isolierschicht (17), die auf der gemeinsamen Elektrodenschicht und der Gate-Leitungsschicht angeordnet ist;
eine aktive Schicht, eine Source-Drain-Schicht und eine Passivierungsschicht (15), die in dieser Reihenfolge auf der Gate-Isolierschicht angeordnet sind; und
eine Pixelelektrodenschicht (16), die auf der Passivierungsschicht vorgesehen ist;
und wobei die Dickenausgleichsschicht (30) ferner eine erste Ausgleichsschicht (31) und eine zweite Ausgleichsschicht (32) aufweist, wobei die erste Ausgleichsschicht (31) zwischen der Gate-Leitung (12) innerhalb des ersten Bereichs (Z1) und dem ersten Substrat (11) angeordnet ist und in der gleichen Schicht mit der gemeinsamen Elektrodenschicht (13) vorgesehen ist, aber nicht mit der gemeinsamen Elektrodenschicht (13) verbunden ist, und die zweite Ausgleichsschicht (32) sich auf der Passivierungsschicht (15) innerhalb des ersten Bereichs (Z1) befindet und in der gleichen Schicht mit der Pixelelektrodenschicht (16) vorgesehen ist, aber nicht mit der Pixelelektrodenschicht (16) verbunden ist.

5. Anzeigesubstratanordnung nach Anspruch 1, **dadurch gekennzeichnet, dass** eine Schicht aus Schwarzmatrix (22), eine Farbfilmschicht (24) und eine Abstandhalterschicht (23), die strukturiert sind, nacheinander über dem zweiten Substrat (21) abgeschieden sind; und dass die Dickenausgleichsschicht (30) auf der Abstandhalterschicht (23) innerhalb eines Bereichs des zweiten Substrats (21) angeordnet ist, der dem ersten Bereich (Z1) entspricht.

6. Anzeigesubstratanordnung nach Anspruch 1, **dadurch gekennzeichnet, dass** die Funktionsschichten metallische Funktionsschichten aufweisen.

7. Anzeigevorrichtung, **dadurch gekennzeichnet, dass** die Anzeigevorrichtung mit der Anzeigesubstratanordnung nach einem der Ansprüche 1-6 versehen ist.

8. Verfahren zur Herstellung der Anzeigesubstratanordnung nach Anspruch 1, wobei das Verfahren umfasst:
Vorsehen des ersten Substrats (11) und des zweiten Substrats (21), die eine Funktionsschicht bilden; und
Bilden der Dickenausgleichsschicht (30).

9. Verfahren zur Herstellung der Anzeigesubstratanordnung nach Anspruch 8, wobei die Funktionsschichten eine gemeinsame Elektrodenschicht (13), eine Gate-Leitungsschicht, eine Gate-Isolierschicht, eine aktive Schicht, eine Source-Drain-Schicht und eine Passivierungsschicht aufweisen, und der Schritt des Bildens der Dickenausgleichsschicht (30) innerhalb des ersten Bereichs (Z1) des ersten Substrats (11) umfasst:
Abscheiden einer Dünnfilmschicht einer gemeinsamen Elektrode auf dem ersten Substrat (11); und
Bilden der gemeinsamen Elektrodenschicht (13) und der Dickenausgleichsschicht (30), die nicht miteinander verbunden werden, durch einen Strukturierungsprozess, wobei sich die Dickenausgleichsschicht (30) zwischen der Gate-Leitung (12) innerhalb des ersten Bereichs (Z1) und dem ersten Substrat (11) befindet.

10. Verfahren zur Herstellung der Anzeigesubstratanordnung nach Anspruch 8, **dadurch gekennzeichnet, dass** der Schritt des Bildens der Dickenausgleichsschicht (30) innerhalb des ersten Bereichs (Z1) des ersten Substrats (11) umfasst:
Vorsehen einer gemeinsamen Elektrodenschicht (13) und einer Gate-Leitungsschicht, die aus Gate-Leitungen (12) hergestellt ist, auf dem ersten Substrat, Vorsehen einer Gate-Isolierschicht (17) auf der gemeinsamen Elektrodenschicht und der Gate-Leitungsschicht, Vorsehen einer aktiven Schicht, einer Source-Drain-Schicht und einer Passivierungsschicht (15) auf der Gate-Isolierschicht;
Abscheiden einer Pixelelektroden-Dünnfilmschicht auf der Passivierungsschicht (15); und
Bilden einer Pixelelektrodenschicht (16) und der Dickenausgleichsschicht (30), die nicht miteinander verbunden sind, durch einen Strukturierungsprozess.

11. Verfahren zur Herstellung der Anzeigesubstratanordnung nach Anspruch 8, **dadurch gekennzeichnet, dass** der Schritt des Bildens der Dickenausgleichsschicht (30) innerhalb des ersten Bereichs (Z1) des ersten Substrats (11) umfasst:
Abscheiden einer Dünnfilmschicht einer gemeinsamen Elektrode auf dem ersten Substrat (11); und
Bilden der gemeinsamen Elektrodenschicht (13) und einer ersten Ausgleichsschicht (31), die nicht miteinander verbunden sind, durch einen Strukturierungsprozess, wobei die erste Ausgleichsschicht (31) zwischen den Gate-Leitungen (12) innerhalb des ersten Bereichs (Z1) und dem ersten Substrat (11) angeordnet wird, und die erste Ausgleichsschicht (31) jeweils in Kontakt mit den Gate-Leitungen (12) und dem ersten Substrat (11) steht;
Vorsehen einer Gate-Leitungsschicht, die aus Gate-Leitungen (12) in der gleichen Schicht wie die gemeinsame Elektrodenschicht hergestellt wird, einer Gate-Isolierschicht (17) auf der gemeinsamen Elektrodenschicht und der Gate-Leitungsschicht, und einer aktiven Schicht, einer Source-Drain-Schicht und einer Passivierungsschicht (15) auf der Gate-Isolierschicht;
Abscheiden einer Pixelelektroden-Dünnfilmschicht auf der Passivierungsschicht (15); und
Bilden der Pixelelektrodenschicht (16) und einer zweiten Ausgleichsschicht (32), die nicht miteinander verbunden werden, durch einen Strukturierungsprozess, wobei die Dickenausgleichsschicht (30) die erste Ausgleichsschicht (31) und die zweite Ausgleichsschicht (32) aufweist.

12. Verfahren zur Herstellung der Anzeigesubstratanordnung nach Anspruch 8, **dadurch gekennzeichnet, dass** der Schritt des Bildens der Dickenausgleichsschicht (30) innerhalb eines Bereichs des zweiten Substrats (21), der dem ersten Bereich (Z1) entspricht, umfasst:
Vorsehen einer Schicht aus Schwarzmatrix (22), einer Farbfilmschicht (24) und einer Abstandhalterschicht (23), die mehrere Abstandhalter aufweist, die sich auf der Schicht aus Schwarzmatrix (22) befinden, die strukturiert worden sind, auf dem zweiten Substrat (21), in dieser Reihenfolge;
Abscheiden einer Ausgleichsdünnfilmschicht auf der Abstandhalterschicht (23); und
Bilden der Dickenausgleichsschicht (30) auf dem Abstandhalter durch einen Strukturierungsprozess innerhalb eines Bereichs des zweiten Substrats (21), der dem ersten Bereich (Z1) entspricht.

## Revendications

1. Ensemble formant substrat d'affichage, comprenant un premier substrat (11) et un second substrat (21) opposés l'un à l'autre, le premier substrat (11) comprenant une première zone (Z1) et une seconde zone (Z2), et une épaisseur totale de couches fonctionnelles (12,13,14,15,16) dans la première zone (Z1) étant inférieure à une épaisseur totale de couches fonctionnelles (12,13,14,15,16) dans la seconde zone (Z2) du premier substrat (11) ; dans lequel
une couche de compensation d'épaisseur (30) est prévue sur le premier substrat (11) ; une position de la couche de compensation d'épaisseur (30) correspond à une position de la première zone (Z1), et une somme d'épaisseurs d'une épaisseur de la couche de compensation d'épaisseur (30) et de l'épaisseur totale des couches fonctionnelles (12,13,14,15,16) dans la première zone (Z1) est égale à une épaisseur totale des couches fonctionnelles (12,13,14,15,16) dans la seconde zone (Z2) ;
**caractérisé en ce**
**qu'**une pluralité de coussins espaceurs (14) sont prévus au-dessus du premier substrat (11) ; la pluralité de coussins espaceurs (14) étant prévus dans la même couche avec une couche de source-drain mais n'étant pas connectés à la couche de source-drain,
la couche de compensation d'épaisseur comprenant la pluralité de coussins espaceurs (14), de sorte que les coussins espaceurs (14) sont des coussins de compensation d'épaisseur (14), les coussins de compensation d'épaisseur (14) étant prévus à des endroits correspondant à des espaceurs (23) prévus sur le second substrat (21).

2. Ensemble formant substrat d'affichage selon la revendication 1, dans lequel les couches fonctionnelles comprennent
une couche d'électrode commune (13) et une couche de lignes de grille composée de lignes de grille (12) qui sont modélisées et disposées sur le premier substrat (11),
et la couche de compensation d'épaisseur (30) se trouve entre la ligne de grille (12) dans la première zone (Z1) et le premier substrat (11), et la couche de compensation d'épaisseur (30) est prévue dans la même couche avec la couche d'électrode commune (13) mais n'est pas connectée à la couche d'électrode commune (13).

3. Ensemble formant substrat d'affichage selon la revendication 1, dans lequel les couches fonctionnelles comprennent
une couche d'électrode commune (13) et une couche de lignes de grille composée de lignes de grille (12) disposée sur le premier substrat (11) ;
une couche d'isolation de grille (17) disposée sur la couche d'électrode commune et la couche de ligne de grille ;
une couche active, la couche de source-drain, et une couche de passivation (15) disposée dans cet ordre sur la couche d'isolation de grille ; et
une couche d'électrodes de pixels (16) prévue sur la couche de passivation ;
et dans lequel la couche de compensation d'épaisseur (30) se trouve sur la couche de passivation (15) dans la première zone (Z1), et la couche de compensation d'épaisseur (30) est prévue dans la même couche avec la première couche d'électrodes de pixels (16) mais n'est pas connectée à la couche d'électrodes de pixels (16).

4. Ensemble formant substrat d'affichage selon la revendication 1, dans lequel les couches fonctionnelles comprennent
une couche d'électrode commune (13) et une couche de lignes de grille composée de lignes de grille (12) disposée sur le premier substrat ;
une couche d'isolation de grille (17) disposée sur la couche d'électrode commune et la couche de lignes de grille ;
une couche active, une couche de source-drain, et une couche de passivation (15) disposées dans cet ordre sur la couche d'isolation de grille ; et
une couche d'électrode de grille (16) prévue sur la couche de passivation ;
et dans lequel la couche de compensation d'épaisseur (30) comprend en outre une première couche de compensation (31) et une seconde couche de compensation (32), la première couche de compensation (31) se trouvant entre la ligne de grille (12) dans la première zone (Z1) et le premier substrat (11) et étant prévue dans la même couche avec la couche d'électrode commune (13) mais n'étant pas à la couche d'électrode commune (13), et la seconde couche de compensation (32) se trouvant sur la couche de passivation (15) dans la première zone (Z1), et étant prévue dans la même couche avec la couche d'électrodes de pixels (16) mais n'étant pas connectée à la couche d'électrode de pixels (16).

5. Ensemble formant substrat d'affichage selon la revendication 1, **caractérisé en ce qu'**une couche de matrice noire (22), une couche de film coloré (24) et une couche d'espacement (23), qui sont modélisées, sont superposées en séquence sur le second substrat (21) ; et que la couche de compensation d'épaisseur (30) se trouve sur la couche d'espacement (23) dans une zone du second substrat (21) correspondant à la première zone (Z1).

6. Ensemble formant substrat d'affichage selon la revendication 1, **caractérisé en ce que** les couches fonctionnelles comprennent des couches fonctionnelles métalliques.

7. Appareil d'affichage, **caractérisé en ce que** l'appareil d'affichage est prévu avec l'ensemble formant substrat d'affichage selon l'une quelconque des revendications 1 à 6.

8. Procédé de fabrication de l'ensemble formant substrat d'affichage selon la revendication 1, le procédé comprenant
la prévision du premier substrat (11) et du second substrat (21) formant des couches fonctionnelles, et
le formage de la couche de compensation d'épaisseur (30).

9. Procédé de fabrication de l'ensemble formant substrat d'affichage selon la revendication 8, dans lequel les couches fonctionnelles comprennent une couche d'électrode commune (13), une couche de lignes de grille, une couche d'isolation de grille, une couche active, une couche de source-drain, et une couche de passivation, et l'étape de formage de la couche de compensation d'épaisseur (30) dans la première zone (Z1) du premier substrat (11) comprend :
le dépôt d'une couche de film mince d'électrode commune sur le premier substrat (11) ; et
le formage, par un procédé de modélisation, de la couche d'électrode commune (13) et de la couche de compensation d'épaisseur (30) qui ne sont pas connectées l'une à l'autre, la couche de compensation d'épaisseur (30) se trouvant entre la ligne de grille (12) dans la première zone (Z1) et le premier substrat (11)

10. Procédé de fabrication de l'ensemble formant substrat d'affichage selon la revendication 8, **caractérisé en ce que** l'étape de formage de la couche de compensation d'épaisseur (30) dans la première zone (Z1) du premier substrat (11) comprend :
la prévision d'une couche d'électrode commune (13) et d'une couche de lignes de grille composée de lignes de grille (12) sur le premier substrat, la prévision d'une couche d'isolation de grille (17) sur la couche d'électrode commune et la couche de lignes de grille, la prévision d'une couche active, d'une couche de source-drain et d'une couche de passivation (15) sur la couche d'isolation de grille ;
le dépôt d'une couche de film mince d'électrode de pixels sur la couche de passivation (15) ; et
le formage, par un procédé de modélisation, d'une couche d'électrodes de pixels (16) et de la couche de compensation d'épaisseur (30) qui ne sont pas connectées l'une à l'autre.

11. Procédé de fabrication de l'ensemble formant substrat d'affichage selon la revendication 8, **caractérisé en ce que** l'étape de formage de la couche de compensation d'épaisseur (30) dans la première zone (Z1) du premier substrat (11) comprend :
le dépôt d'une couche de film mince d'électrode de pixels sur le premier substrat (11) ; et
le formage, par un procédé de modélisation, de la couche d'électrode commune (13) et d'une première couche de compensation (31) qui ne sont pas connectées l'une à l'autre, la première couche de compensation (31) se trouvant entre les lignes de grille (12) dans la première zone (Z1) et le premier substrat (11), et la première couche de compensation (31) étant en contact respectivement avec les lignes de grille (12) et le premier substrat (11) ;
la prévision d'une couche de lignes de grille composée de lignes de grille (12) dans la même couche que la couche d'électrode commune, d'une couche d'isolation de grille (17) sur la couche d'électrode commune et de la couche de lignes de grille, et d'une couche active, d'une couche de source - drain, et d'une couche de passivation (15) sur la couche d'isolation de grille ;
le dépôt d'une électrode de couche de film mince d'électrode de pixels sur la couche de passivation (15) ; et
le formage, par un procédé de modélisation, de la couche d'électrodes de pixels (16) et d'une seconde couche de compensation (32) qui ne sont pas connectées l'une à l'autre, la couche de compensation d'épaisseur (30) comprenant la première couche de compensation (31) et la seconde couche de compensation (32).

12. Procédé de fabrication de l'ensemble formant substrat d'affichage selon la revendication 8, **caractérisé en ce que** l'étape de formage de la couche de compensation d'épaisseur (30) dans une zone du second substrat (21) correspondant à la première zone (Z1) comprend :
la prévision d'une couche de matrice noire (22), d'une couche de film coloré (24) et d'une couche d'espacement (23) comprenant une pluralité d'espaceurs sur la couche de matrice noire (22) et qui ont été modélisés, sur le second substrat (21) dans cet ordre ;
le dépôt d'une électrode de couche de film mince de compensation sur la couche d'espacement (23) ; et
le formage, par un procédé de modélisation, de la couche de compensation d'épaisseur (30) dans une zone du second substrat (21) correspondant à la première zone (Z1).
